# EUROPEAN PATENT SPECIFICATION

(11) **EP 3 113 302 B1**
(45) Date of publication and mention of the grant of the patent: **04.04.2018**
(21) Application number: 15306082.7
(22) Date of filing: 02.07.2015
(51) Int. Cl.: H01S 5/022, H01S 5/068, H01S 5/40, H01S 5/50

(54) **OPTICAL AMPLIFICATION DEVICE COMPRISING SEMICONDUCTOR OPTICAL AMPLIFIERS**
VORRICHTUNG ZUR OPTISCHEN VERSTÄRKUNG MIT OPTISCHEN HALBLEITERVERSTÄRKERN
DISPOSITIF D'AMPLIFICATION OPTIQUE COMPRENANT DES AMPLIFICATEURS OPTIQUES À SEMI-CONDUCTEURS

(43) Date of publication of application: 04.01.2017
(73) Proprietor: ALCATEL LUCENT, 92100 Boulogne-Billancourt (FR)
(72) Inventor: CHARLET, Gabriel, 91620 Nozay (FR); RENAUDIER, Jérémie, 91620 Nozay (FR)
(74) Representative: Berthier, Karine

(56) References cited:
- WO-A1-2014/129613
- US-B1- 6 747 793
- MATIJA DZANKO ET AL: "Availability of all-optical switching fabrics used in optical cross-connects", MIPRO, 2012 PROCEEDINGS OF THE 35TH INTERNATIONAL CONVENTION, IEEE, 21 May 2012 (2012-05-21), pages 568-572, XP032201978, ISBN: 978-1-4673-2577-6
- AZZAM YASSEEN A ET AL: "A Rotary Electrostatic Micromotor 18 Optical Switch", IEEE JOURNAL OF SELECTED TOPICS IN QUANTUM ELECTRONICS, IEEE SERVICE CENTER, PISCATAWAY, NJ, US, vol. 5, no. 1, 1 February 1999 (1999-02-01), XP011062464, ISSN: 1077-260X

## Description

### Field of the Invention

The present invention generally relates to the field of optical communication networks, in particular to optical amplification devices for optical communication networks. More particularly, but not exclusively, the present invention relates to optical amplification devices adapted for being used in undersea optical communication systems.

### Background

In a typical optical communication network, optical signals are transmitted along optical links (typically, optical fibers) between nodes of the network. Typically, each optical signal results from the digital modulation of the amplitude and/or phase of the light emitted by a light source (such as a laser) included in a transmitter of a node, at a certain wavelength, and it propagates along an optical fiber.

For increasing the capacity of the optical fiber, it is also known to implement the Wavelength Division Multiplexing (WDM) technique, which consists in transmitting, along a same optical fiber, two or more optical signals onto light carriers having distinct wavelengths.

In a typical undersea optical communication network, the lengths of the optical links between two successive nodes of the network are extremely high. Thus, some optical amplification devices need to be used in such a network, so as to ensure an efficient propagation of the signal. However, the use of such an optical communication system under the sea involves some access and maintenance constraints. Thus, with the use of such an optical communication system under the sea comes the problem of the reliability of the system.

Some solutions exist for enhancing the reliability of such an undersea system.

For example, an optical amplification device has been proposed that comprises two laser-based optical pumps combined with an extremely reliable 3 dB optical coupler. The two optical pumps are used in parallel. The two pumps inject their pumped signal, for each direction of optical transmission, into an Erbium doped fiber. The or each Erbium doped fiber is connected to two optical fibers, via optical couplers, thereby forming an optical transmission path for the optical signals. Thus, no active component is directly on the path of the optical signal. This ensures an excellent reliability of the system. Indeed, failure of one pump induces a loss of 3dB of pump power, hence a small Optical Signal-to-Noise Ratio (OSNR) degradation for the complete line.

However, such optical amplification devices used in undersea systems do not allow amplifying extremely wide optical bandwidth. Since total capacity of transport in undersea systems is currently approaching the maximum capacity allowed by currently used optical amplification bandwidth, the increase of optical bandwidth becomes mandatory to avoid future capacity bottleneck in undersea systems.

There is thus a need for a reliable optical amplification device that would allow amplifying extremely wide optical bandwidth.

The article "Availability of all-optical switching fabrics used in optical cross-connects" from MATIJA DZANKO ET AL. (ISBN: 978-1-4673-2577-6) discloses an optical amplification device comprising amplifier modules and switching assemblies comprising micro-mechanical systems with rotation elements allowing for a proper interconnect of fibers and/or amplifiers.

### Summary

So an object of this invention is to provide an optical amplification device allowing to amplify extremely wide optical bandwidth, while being reliable.

According to a first aspect, the present invention provides an optical amplification device comprising:
- at least one input optical fiber arranged within a first element and intended to receive an input optical signal,
- at least one output optical fiber arranged within a second element and intended to provide an output optical signal,
- at least one set of at least two amplifier modules, the or each set of amplifier modules being arranged within a third element, each amplifier module comprising at least one semiconductor optical amplifier, the or each third element being arranged between the or one of the first element(s) and the or one of the second element(s) so that, in a first configuration of the device, at least one amplifier module of the set arranged within said third element is on the optical path of one input optical fiber and one output optical fiber,
- means for monitoring the state of each semiconductor optical amplifier, said means being configured to detect a default or failure of said semiconductor optical amplifier,
- means for mechanically moving the device from the first configuration to at least one second configuration, said moving means being connected to the monitoring means so that the moving means are adapted to move the device from the first configuration to the second configuration upon receipt of a default or failure detection signal of one of the semiconductor optical amplifiers,
the device being configured so that, in the or each second configuration, for the or one of the third element(s) associated to one set of amplifier modules, no more optical signal is injected within the amplifier module comprising the default or failed semiconductor optical amplifier;
wherein the or each third element is fixed permanently and the or each second element is a rotating element mounted around a rotation axis, the moving means being configured to drive the or each second element around its rotation axis.

Semiconductor optical amplifiers have the capability to amplify extremely wide optical bandwidth. Besides, with such an advantageous configuration for the amplification device, in case of failure of one semiconductor optical amplifier, the third element or the first and second elements are moved from the first configuration to the second configuration of the device so that to avoid sending any signal in the default or failed semiconductor optical amplifier. Advantageously, with this optical amplification device according to the present invention, at least one semiconductor optical amplifier can fails at each amplification device location without interrupting the optical transmission.

The optical amplification device may include additional characteristics considered separately or combined, and notably:
- in the first configuration of the device, when an input optical signal is injected within the or at least one of the input optical fiber(s), thereby defining this or these input optical fiber(s) as active input optical fiber(s), for the or each third element associated to one set of amplifier modules, the number of amplifier modules of said set is strictly greater than the number of active input optical fiber(s) arranged within the first element that is disposed facing the third element associated to said set of amplifier modules ;
- in the or each second configuration of the device, for the set of amplifier modules having the amplifier module comprising the default or failed semiconductor optical amplifier, the or one of the amplifier module(s) of said set that was not on the optical path of an active input optical fiber in the first configuration of the device is on the optical path of one active input optical fiber and one output optical fiber;
- each amplifier module comprises two parallel semiconductor optical amplifiers, each semiconductor optical amplifier being intended to amplify one particular polarization of the received input optical signal ;
- the monitoring means comprise at least two photodiodes, each photodiode being arranged so as to receive at least part of one of the amplified optical signals provided by an amplifier module ;
- the or each third element comprises at least one lens arranged upstream or downstream one of the semiconductor optical amplifiers, on a same optical path of said amplifier, said lens being configured to focus light going in or coming from said amplifier;
- at least one of the first and second elements comprises a collimator arranged on a same optical path as that of the or one of the optical fiber(s) that is (are) arranged within said element;
- the collimator includes a lens configured to focus light going in or coming from the or one of the optical fiber(s) that is (are) arranged within said element;
- the number of amplifier modules is strictly greater than the number of output optical fiber(s) ;
- the or each third element is fixed permanently and the or each second element is a rotating element mounted around a rotation axis, the moving means being configured to drive the or each second element around its rotation axis ;
- the device comprises at least two sets of at least two input optical fibers and at least two sets of at least two output optical fibers, the device further comprising at least two sets of at least three amplifier modules, the input optical fibers of separate sets of input optical fibers being arranged within separate first elements, the output optical fibers of separate sets of output optical fibers being arranged within separate second elements, the amplifier modules of separate sets of amplifier modules being arranged within separate third elements ;
- the or each third element is fixed permanently, and the or each first element is a rotating element mounted around a rotation axis, the moving means being configured to drive the or each first element around its rotation axis, so as to move the device from the first configuration to the or each second configuration.

According to a second aspect, the present invention provides an optical communication system comprising a plurality of cascaded optical amplification devices, wherein each optical amplification device is as set forth above.

The optical communication system may include the additional feature wherein the optical communication system is an undersea system.

### Brief Description of the Figures

Some embodiments of apparatus and/or methods in accordance with embodiments of the present invention are now described, by way of example only, and with reference to the accompanying drawings, in which :
- The Figure 1 schematically and functionally illustrates an optical communication system comprising three optical amplification devices according to the present invention,
- The Figure 2 schematically and functionally illustrates one of the optical amplification devices of Figure 1 according to a first embodiment of the present invention, the device comprising a first element, a second element and a third element,
- The Figures 3 to 5 are respective sectional views, taken respectively along the axes III-III, IV-IV and V-V, of the first, second and third elements of the device of Figure 2, in a first configuration of the device,
- The Figures 6 to 8 are respective sectional views, taken respectively along the axes III-III, IV-IV and V-V, of the first, second and third elements of the device of Figure 2, in a second configuration of the device,
- The Figure 9 schematically and functionally illustrates one of the optical amplification devices of Figure 1 according to a second embodiment of the present invention,
- The Figure 10 schematically and functionally illustrates one of the optical amplification devices of Figure 1 according to a third embodiment of the present invention.

### Description of Embodiments

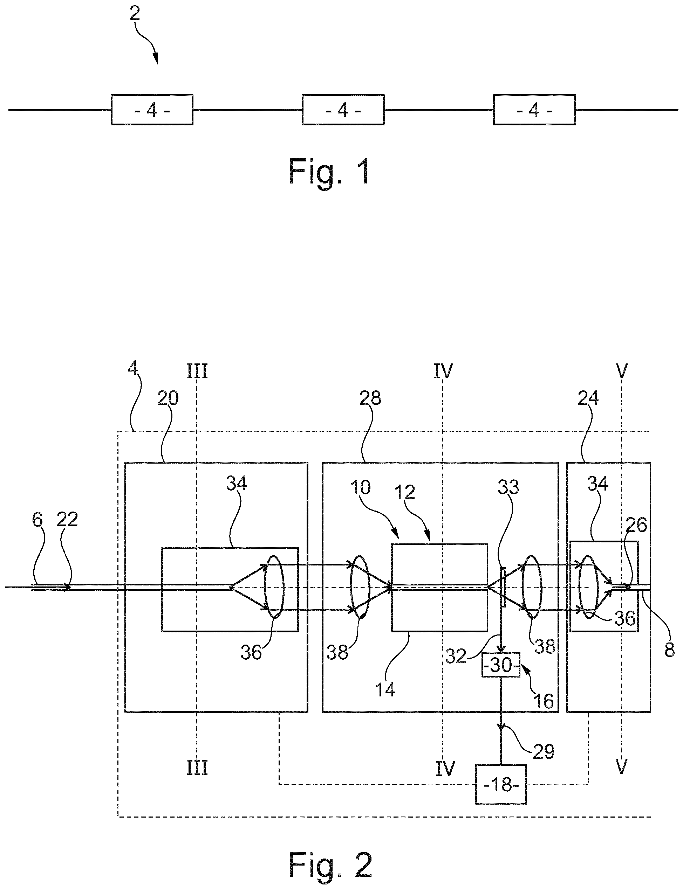

Figure 1 shows an optical communication system 2. In the exemplary embodiment of Figure 1, the optical communication system 2 is an undersea system.

The optical communication system 2 is connected upstream and downstream to a communication network, for example a WDM communication network. The optical communication system 2 comprises several cascaded optical amplification devices 4. Only three optical amplification devices 4 are shown on Figure 1, although the optical communication system 2 can include a much larger number of devices, for example the optical communication system can include up to several hundred devices.

Each optical amplification device 4 comprises at least one input optical fiber 6, at least one output optical fiber 8, and at least one set 10 of at least two amplifier modules 12. Each amplifier module 12 comprises at least one semiconductor optical amplifier (SOA) 14. In the exemplary embodiment of Figures 2 to 8, each optical amplification device 4 comprises five input optical fibers 6, five output optical fibers 8 and one set 10 of six amplifier modules 12, each amplifier module 12 comprising one SOA 14. Each optical amplification device 4 further comprises means 16 for monitoring the state of each SOA 14, and means 18 for mechanically moving the optical amplification device 4 from a first configuration to at least one second configuration.

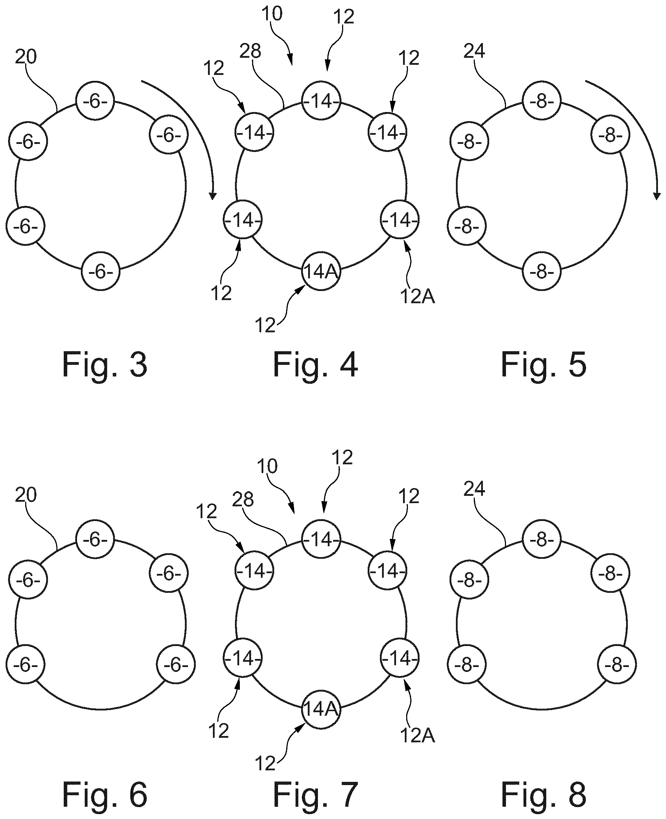

Preferably, as shown in Figures 4, 5, 7 and 8, the number of amplifier modules 12 is strictly greater than the number of output optical fiber(s) 8. Advantageously, this feature allows reducing the manufacturing costs of the device 4.

The or each input optical fiber 6 is arranged within a first element 20 and is intended to receive an input optical signal 22. The or each output optical fiber 8 is arranged within a second element 24 and is intended to provide an output optical signal 26. The or each set 10 of amplifier modules 12 is arranged within a third element 28.

By "arranged within" it is meant any permanent arrangement of a first element towards a second element, may the first element be physically located inside the second member or on an outer surface thereof.

In the exemplary embodiment of Figures 2 to 8, the optical amplification system 4 comprises one first element 20 within which are arranged the five input optical fibers 6, one second element 24 within which are arranged the five output optical fibers 8, and one third element 28 within which is arranged the set 10 of amplifier modules 12.

The monitoring means 16 are configured to detect a default or failure of each SOA 14, and to provide a default or failure detection signal 29 of one of the SOA 14. The monitoring means 16 comprise for example at least two photodiodes 30. This feature allows to have a high reliability for the detection of a default or failure of the SOA 14. In the exemplary embodiment of Figures 2 to 8, the monitoring means 16 comprise six photodiodes 30, even though only one photodiode 30 is shown on Figure 2 for clarity reasons.

Each photodiode 30 is arranged so as to receive at least part of one of the amplified optical signals provided by an amplifier module 12. In the exemplary embodiment of Figures 2 to 8, each photodiode 30 is arranged so as to receive part of one of the amplified optical signals provided by an amplifier module 12, said part of an amplified optical signal being a signal 32 that is for example deflected by a semi-reflecting mirror 33.

The moving means 18 are connected to the monitoring means 16 so that the moving means 18 are adapted to move the optical amplification device 4 from the first configuration to the or one of the second configuration(s) upon receipt of a default or failure detection signal 29 of one of the SOA 14.

The or each third element 28 is arranged between the or one of the first element(s) 20 and the or one of the second element(s) 24 so that, in the first configuration of the optical amplification device 4, at least one amplifier module 12 of the set 10 arranged within said third element 28 is on the optical path of one input optical fiber 6 and one output optical fiber 8. Besides, the optical amplification device 4 is configured so that, in the or each second configuration of the device, for the or one of the third element(s) 28 associated to one set 10 of amplifier modules 12, no more optical signal is injected within the amplifier module 12 comprising the default or failed SOA 14 detected by the monitoring means 16. In the exemplary embodiment of Figures 2 to 8, the third element 28 is arranged between the first element 20 and the second element 24 so that, in the first configuration of the optical amplification device 4, there are five amplifier modules 12 of the set 10 arranged within said third element 28 that are each on the optical path of one input optical fiber 6 and one output optical fiber 8, as shown in Figures 3, 4 and 5. Besides, in this exemplary embodiment wherein the optical amplification device 4 has five second configurations, in each second configuration, for the third element 28 associated to the set 10 of amplifier modules 12, no more optical signal is injected within the amplifier module 12 comprising the default or failed SOA 14, as will be described below in greater details with reference to Figures 6 to 8.

More precisely, but not necessarily, in the first configuration of the optical amplification device 4, when an input optical signal 22 is injected within the or at least one of the input optical fiber(s) 6, thereby defining this or these input optical fiber(s) 6 as active input optical fiber(s), for the or each third element 28 associated to one set 10 of amplifier modules 12, the number of amplifier modules 12 of said set 10 is strictly greater than the number of active input optical fiber(s) 6 arranged within the first element 20 that is disposed facing the third element 28 associated to said set 10 of amplifier modules 12. In the exemplary embodiment of Figures 2 to 8, the first element 20 of the optical amplification device 4 includes five active input optical fibers 6 in the first configuration of the device, and the third element 28 includes a set 10 of six amplifier modules 12.

Preferably, but not necessarily, in the or each second configuration of the optical amplification device 4, for the set 10 of amplifier modules 12 having the amplifier module comprising the default or failed SOA 14, the or one of the amplifier module(s) 12 of said set 10 that was not on the optical path of an active input optical fiber 6 in the first configuration of the device is on the optical path of one active input optical fiber 6 and one output optical fiber 8. In the exemplary embodiment of Figures 2 to 8, in each of the five second configurations of the optical amplification device 4, for the set 10 of amplifier modules 12 having the amplifier module comprising the default or failed SOA 14, one of the amplifier modules 12 of said set 10 that was not on the optical path of an active input optical fiber 6 in the first configuration of the device is on the optical path of one active input optical fiber 6 and one output optical fiber 8. One of these particular second configurations of the optical amplification device 4 is for example shown in Figures 6 to 8.

Though not represented in the Figures for clarity reasons, the moving means 18 may for example comprise a motor-driven rotational axis with predefined positioning cycles.

Preferably, at least one of the first and second elements 20, 24 comprises a collimator 34 arranged on a same optical path as that of the or one of the optical fiber(s) 6, 8 that is (are) arranged within said element 20, 24. Advantageously, this feature allows correcting divergence of the optical beam and thus reducing transmission loss. In the exemplary embodiment of Figures 2 to 8, each of the first and second elements 20, 24 comprises five collimators 34, each collimator 34 of a given element 20, 24 being arranged on a same optical path as that of one of the input or output optical fibers 6, 8 that are arranged within said element 20, 24.

Preferably, each collimator 34 includes a lens 36, as shown in the exemplary embodiment of Figure 2. Each lens 36 of a given element 20, 24 is configured to focus light going in or coming from one of the optical fibers 6, 8 that are arranged within said element 20, 24.

Each of the first and second elements 20, 24 is for example configured as a cylinder. In the exemplary embodiment of Figures 2 to 8, the third element 28 is fixed permanently and the first element 20 is a rotating element mounted around a rotation axis. The moving means 18 are configured to drive the first element 20 around its rotation axis, so as to move the optical amplification device 4 from the first configuration to each second configuration. These last three features allow avoiding power supply constraints for the amplifier modules 12, due for example to wirings. Preferably, as shown in Figures 2, 5 and 8, the second element 24 is also a rotating element mounted around a rotation axis and the moving means 18 are configured to drive the second element 24 around its rotation axis.

Preferably, the third element 28 comprises at least one lens 38 arranged upstream or downstream one of the SOA 14, on a same optical path of said SOA 14. The or each lens 38 arranged upstream or downstream one of the SOA 14 is configured to focus light going in or coming from said SOA 14. In the exemplary embodiment of Figures 2 to 8, the third element 28 comprises twelve lenses 38. More precisely, the third element 28 comprises six first lenses 38 that are each arranged upstream one distinct SOA 14, on a same optical path of said SOA 14, and six other lenses 38 that are each arranged downstream one distinct SOA 14, on a same optical path of said SOA 14.

The third element 28 is for example configured as a cylinder, said cylinder having a set 10 of six angularly equispaced amplifier modules 12.

The operation of the optical amplification device 4 shown in Figures 2 to 8, according to the first embodiment of the present invention, will now be described.

Initially, in the first configuration of the optical amplification device 4, the five input optical fibers 6 are all active input fibers. In this first configuration of the device, five amplifier modules 12 of the set 10 arranged within the third element 28 are each on the optical path of one input optical fiber 6 and one output optical fiber 8, as shown in Figures 3, 4 and 5. The other amplifier module 12A of the set 10 arranged within the third element 28 is not on the optical path of an active input optical fiber 6.

When a default or failure of one particular SOA 14A, belonging to one of said five amplifier modules 12, is detected by the monitoring means 16, the monitoring means 16 transmit a default or failure detection signal 29 to the moving means 18. Upon receipt of the default or failure detection signal 29, the moving means 18 move the optical amplification device 4 from the first configuration to one of the second configurations, which is shown in Figures 6 to 8. More precisely, the moving means 18 move the first and second elements 20, 24 around their respective rotation axis, so as to move the optical amplification device 4 from the first configuration to said second configuration, as shown in Figures 3 and 5.

In this second configuration, no more optical signal is injected within the amplifier module 12 comprising the default or failed SOA 14A. More precisely, the amplifier module 12 comprising the default or failed SOA 14A is no more on the optical path of an active input optical fiber 6. Besides, the amplifier module 12A, that was not on the optical path of an active input optical fiber 6 in the first configuration of the device 4, is now on the optical path of one active input optical fiber 6 and one output optical fiber 8.

Thus, this amplifier module 12A stands for a relief amplifier module that avoids a maintenance work for replacing the amplifier module 12 comprising the default or failed SOA 14A.

It is hence conceivable that the optical amplification device according to the invention allows amplifying extremely wide optical bandwidth, while being reliable.

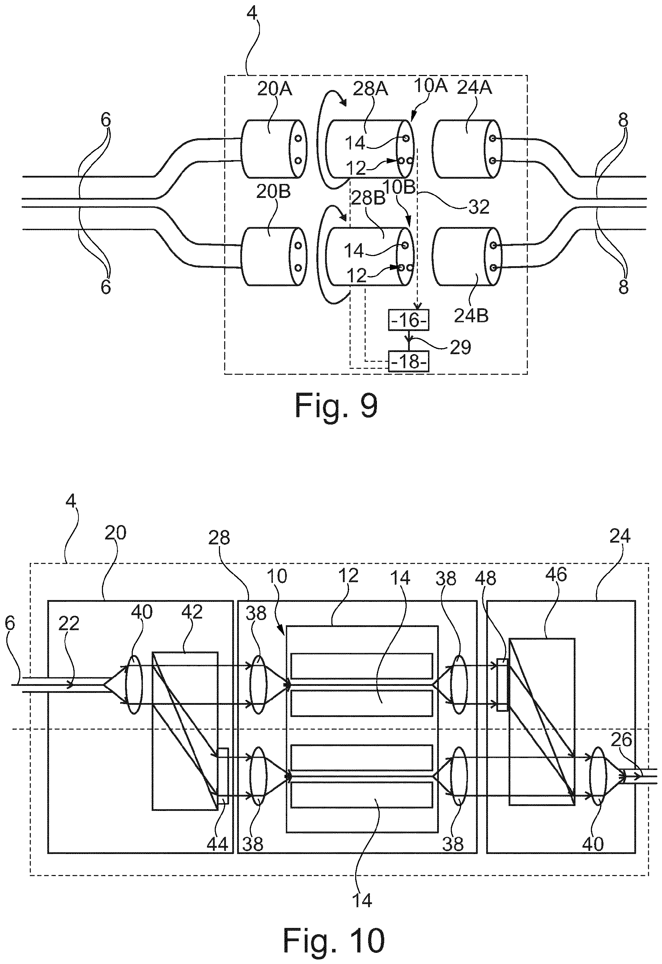

Figure 9 illustrates a second embodiment of the optical amplification device according to the invention wherein elements similar to the first embodiment described above are identified by identical reference numbers and thus are not described again.

In the exemplary embodiment of Figure 9, the optical amplification device 4 comprises two pairs of input optical fibers 6, two pairs of output optical fibers 8 and two sets 10A, 10B of amplifier modules 12, each set 10A, 10B having three amplifier modules 12. Each amplifier module 12 comprises one SOA 14.

The first pair of input optical fibers 6 is arranged within a first element 20A, and the other pair of input optical fibers 6 is arranged within another first element 20B. The first pair of output optical fibers 8 is arranged within a second element 24A, and the other pair of output optical fibers 8 is arranged within another second element 24B. A first set 10A of amplifier modules 12 is arranged within a third element 28A. A second set 10B of amplifier modules 12 is arranged within another third element 28B.

Each third element 28A, 28B is arranged between one first element 20A, 20B and one second element 24A, 24B so that, in the first configuration of the optical amplification device 4, two amplifier modules 12 of the set 10A, 10B arranged within said third element 28A, 28B are each on the optical path of one input optical fiber 6 and one output optical fiber 8, as shown in Figure 9. Besides, in this exemplary embodiment wherein the optical amplification device 4 has two second configurations per third element 28A, 28B (i.e. four second configurations in total), in each second configuration, for one of the third elements 28A, 28B comprising a set 10A, 10B of amplifier modules 12, no more optical signal is injected within the amplifier module 12 comprising the default or failed SOA 14.

More precisely, in the exemplary embodiment of Figure 9, each first element 20A, 20B of the optical amplification device 4 includes two active input optical fibers 6 in the first configuration of the device, and each third element 28A, 28B includes a set 10A, 10B of three amplifier modules 12. Besides, in each of the four second configurations of the optical amplification device 4, for the set 10A, 10B of amplifier modules 12 having the amplifier module comprising the default or failed SOA 14, one of the amplifier modules 12 of said set 10A, 10B that was not on the optical path of an active input optical fiber 6 in the first configuration of the device is on the optical path of one active input optical fiber 6 and one output optical fiber 8.

In this exemplary embodiment of Figure 9, the first elements 20A, 20B and the second elements 24A, 24B are fixed permanently and each third element 28A, 28B is a rotating element mounted around a rotation axis. The moving means 18 are configured to drive the third elements 28A, 28B independently around their respective rotation axis, so as to move the optical amplification device 4 from the first configuration to each second configuration.

More generally, the optical amplification device 4 according to the second embodiment of the invention comprises at least two sets of at least two input optical fibers 6, at least two sets of at least two output optical fibers 8, and at least two sets of at least three amplifier modules 12, the input optical fibers 6 of separate sets of input optical fibers being arranged within separate first elements, the output optical fibers 8 of separate sets of output optical fibers being arranged within separate second elements, the amplifier modules 12 of separate sets of amplifier modules being arranged within separate third elements.

Compared to the first embodiment, the optical amplification device 4 according to this second embodiment offers an enhanced reliability, due to the presence of at least one relief amplifier module 12 per set 10A, 10B of amplifier modules 12.

The operation of this second embodiment of the optical amplification device 4 is similar to that of the first embodiment and is therefore not described in greater detail.

Figure 10 illustrates a third embodiment of the optical amplification device according to the invention wherein elements similar to the first embodiment described above are identified by identical reference numbers and thus are not described again.

In this third embodiment, the optical amplification system 4 comprises one first element 20 within which are arranged five input optical fibers 6, one second element 24 within which are arranged five output optical fibers 8, and one third element 28 within which is arranged a set 10 of six amplifier modules 12.

Each amplifier module 12 comprises two parallel SOA 14. Each SOA 14 of a given amplifier module 12 is intended to amplify one particular polarization of the received input optical signal 22.

Each of the first and second elements 20, 24 comprises five lenses 40, each lens 40 of a given element 20, 24 being arranged on a same optical path as that of one of the input or output optical fibers 6, 8 that are arranged within said element 20, 24.

Besides, the first element 20 comprises five optical polarizers 42, each polarizer 42 being arranged downstream one of the lenses 40 of said first element 20, on a same optical path as that of said lens 40. Each polarizer 42 comprises a half waveplate 44 arranged on substantially half of the length of one of its outer faces.

The second element 24 comprises five optical analyzers 46, each analyzer 46 being arranged upstream one of the lenses 40 of said second element 24, on a same optical path as that of said lens 40. Each analyzer 46 comprises a half waveplate 48 arranged on substantially half of the length of one of its outer faces.

The third element 28 comprises twelve first lenses 38 that are each arranged upstream one distinct SOA 14, on a same optical path of said SOA 14, and twelve second lenses 38 that are each arranged downstream one distinct SOA 14, on a same optical path of said SOA 14.

Each half waveplate 44 is arranged to face one of the first lenses 38 of the third element 28, so as to provide one particular polarization of the received input optical signal 22 to one of the SOA 14. Each half waveplate 48 is arranged to face one of the second lenses 38 of the third element 28, so as to receive one particular polarization of the amplified optical signal provided by one of the SOA 14.

Compared to the first embodiment, the optical amplification device 4 according to this third embodiment allows reducing noise while getting enhanced output power. The performances of the optical amplification device 4 are thus increased.

The operation of this third embodiment of the optical amplification device 4 is similar to that of the first embodiment and is therefore not described in greater detail.

It should be appreciated by those skilled in the art that any block diagrams herein represent conceptual views of illustrative circuitry embodying the principles of the invention. Similarly, it will be appreciated that any flow charts, flow diagrams, state transition diagrams, pseudo code, and the like represent various processes which may be substantially represented in computer readable medium and so executed by a computer or processor, whether or not such computer or processor is explicitly shown.

The description and drawings merely illustrate the principles of the invention. It will thus be appreciated that those skilled in the art will be able to devise various arrangements that, although not explicitly described or shown herein, embody the principles of the invention and are included within its spirit and scope. In particular, although the present description has been made with reference to an undersea optical communication system, the present invention is not limited to this application and can be extended to any kind of optical communication systems, such as for example terrestrial optical communication systems.

Furthermore, all examples recited herein are principally intended expressly to be only for pedagogical purposes to aid the reader in understanding the principles of the invention and the concepts contributed by the inventor(s) to furthering the art, and are to be construed as being without limitation to such specifically recited examples and conditions. Moreover, all statements herein reciting principles, aspects, and embodiments of the invention, as well as specific examples thereof, are intended to encompass equivalents thereof.

## Claims

1. Optical amplification device (4) comprising:
• at least one input optical fiber (6) arranged within a first element (20 ; 20A, 20B) and intended to receive an input optical signal (22),
• at least one output optical fiber (8) arranged within a second element (24 ; 24A, 24B) and intended to provide an output optical signal (26),
• at least one set (10 ; 10A, 10B) of at least two amplifier modules (12, 12A), the or each set (10 ; 10A, 10B) of amplifier modules (12, 12A) being arranged within a third element (28 ; 28A, 28B), each amplifier module (12, 12A) comprising at least one semiconductor optical amplifier (14, 14A), the or each third element (28 ; 28A, 28B) being arranged between the or one of the first element(s) (20 ; 20A, 20B) and the or one of the second element(s) (24 ; 24A, 24B) so that, in a first configuration of the device (4), at least one amplifier module (12) of the set (10 ; 10A, 10B) arranged within said third element is on the optical path of one input optical fiber (6) and one output optical fiber (8),
• means (16) for monitoring the state of each semiconductor optical amplifier (14, 14A), said means (16) being configured to detect a default or failure of said semiconductor optical amplifier,
• means (18) for mechanically moving the device (4) from the first configuration to at least one second configuration, said moving means (18) being connected to the monitoring means (16) so that the moving means (18) are adapted to move the device (4) from the first configuration to the second configuration upon receipt of a default or failure detection signal (29) of one of the semiconductor optical amplifiers (14, 14A),
the device (4) being configured so that, in the or each second configuration, for the or one of the third element(s) (28 ; 28A, 28B) associated to one set of amplifier modules (12, 12A), no more optical signal is injected within the amplifier module (12) comprising the default or failed semiconductor optical amplifier (14, 14A);
wherein the or each third element (28 ; 28A, 28B) is fixed permanently and the or each second element (24 ; 24A, 24B) is a rotating element mounted around a rotation axis, the moving means (18) being configured to drive the or each second element (24 ; 24A, 24B) around its rotation axis.

2. Optical amplification device (4) according to claim 1, wherein, in the first configuration of the device, when an input optical signal (22) is injected within the or at least one of the input optical fiber(s) (6), thereby defining this or these input optical fiber(s) (6) as active input optical fiber(s), for the or each third element (28 ; 28A, 28B) associated to one set (10 ; 10A, 10B) of amplifier modules (12, 12A), the number of amplifier modules (12, 12A) of said set is strictly greater than the number of active input optical fiber(s) (6) arranged within the first element (20 ; 20A, 20B) that is disposed facing the third element (28 ; 28A, 28B) associated to said set of amplifier modules (12, 12A).

3. Optical amplification device (4) according to claim 2, wherein, in the or each second configuration of the device, for the set (10 ; 10A, 10B) of amplifier modules (12, 12A) having the amplifier module comprising the default or failed semiconductor optical amplifier (14, 14A), the or one of the amplifier module(s) of said set that was not on the optical path of an active input optical fiber in the first configuration of the device is on the optical path of one active input optical fiber (6) and one output optical fiber (8).

4. Optical amplification device (4) according to any one of the preceding claims, wherein each amplifier module (12) comprises two parallel semiconductor optical amplifiers (14), each semiconductor optical amplifier (14) being intended to amplify one particular polarization of the received input optical signal (22).

5. Optical amplification device (4) according to any one of the preceding claims, wherein the monitoring means (16) comprise at least two photodiodes (30), each photodiode (30) being arranged so as to receive at least part of one of the amplified optical signals provided by an amplifier module (12, 12A).

6. Optical amplification device (4) according to any one of the preceding claims, wherein the or each third element (28 ; 28A, 28B) comprises at least one lens (38) arranged upstream or downstream one of the semiconductor optical amplifiers (14, 14A), on a same optical path of said amplifier, said lens (38) being configured to focus light going in or coming from said amplifier.

7. Optical amplification device (4) according to any one of the preceding claims, wherein at least one of the first (20 ; 20A, 20B) and second elements (24 ; 24A, 24B) comprises a collimator (34) arranged on a same optical path as that of the or one of the optical fiber(s) (6, 8) that is (are) arranged within said element.

8. Optical amplification device (4) according to claim 7, wherein the collimator (34) includes a lens (36) configured to focus light going in or coming from the or one of the optical fiber(s) (6, 8) that is (are) arranged within said element.

9. Optical amplification device (4) according to any one of the preceding claims, wherein the number of amplifier modules (12, 12A) is strictly greater than the number of output optical fiber(s) (8).

10. Optical amplification device (4) according to any one of the preceding claims, wherein the device comprises at least two sets of at least two input optical fibers (6) and at least two sets of at least two output optical fibers (8), the device (4) further comprising at least two sets (10A, 10B) of at least three amplifier modules (12), the input optical fibers (6) of separate sets of input optical fibers being arranged within separate first elements (20A, 20B), the output optical fibers (8) of separate sets of output optical fibers being arranged within separate second elements (24A, 24B), the amplifier modules (12) of separate sets (10A, 10B) of amplifier modules being arranged within separate third elements (28A, 28B).

11. Optical amplification device (4) according to any one of the preceding claims, wherein the or each third element (28; 28A, 28B) is fixed permanently, and the or each first element (20; 20A, 20B) is a rotating element mounted around a rotation axis, the moving means (18) being configured to drive the or each first element (20 ; 20A, 20B) around its rotation axis, so as to move the device (4) from the first configuration to the or each second configuration.

12. Optical communication system (2) comprising a plurality of cascaded optical amplification devices (4), wherein each optical amplification device (4) is according to any one of the preceding claims.

13. Optical communication system (2) according to claim 11, wherein the optical communication system (2) is an undersea system.

## Patentansprüche

1. Optische Verstärkungsvorrichtung (4), umfassend:
• mindestens eine optische Eingangsfaser (6), die innerhalb eines ersten Elements (20; 20A, 20B) angeordnet ist und ein optisches Eingangssignal (22) empfangen soll,
• mindestens eine optische Ausgangsfaser (8), die innerhalb eines zweiten Elements (24; 24A, 24B) angeordnet ist und ein optisches Ausgangssignal (26) empfangen soll,
• mindestens einen Satz (10; 10A, 10B) aus mindestens zwei Verstärkermodulen (12, 12A), wobei der oder jeder Satz (10; 10A, 10B) aus Verstärkermodulen (12, 12A) innerhalb eines dritten Elements (28; 28A, 28B) angeordnet ist, jedes Verstärkermodul (12, 12A) mindestens einen Halbleiterlaserverstärker (14, 14A) umfasst, das oder jedes dritte Element (28; 28A, 28B) zwischen dem oder einem der ersten Element(e) (20; 20A, 20B) und dem oder einem der zweiten Element(e) (24; 24A, 24B) angeordnet ist, so dass, in einer ersten Konfiguration der Vorrichtung (4), mindestens ein Verstärkermodul (12) des Satzes (10; 10A, 10B), der innerhalb des besagten dritten Elements angeordnet ist, auf dem optischen Pfad von einer optischen Eingangsfaser (6) und einer optischen Ausgangsfaser (8) ist,
• Mittel (16) zum Überwachen des Status von jedem Halbleiterlaserverstärker (14, 14A), wobei die besagten Mittel (16) zum Erkennen eines Fehlers oder Ausfalls des besagten Halbleiterlaserverstärkers ausgelegt sind,
• Mittel (18) zum mechanischen Bewegen der Vorrichtung (4) von der ersten Konfiguration in mindestens eine zweite Konfiguration, wobei die besagten Bewegungsmittel (18) mit den Überwachungsmitteln (16) verbunden sind, so dass die Bewegungsmittel (18) angepasst sind, um die Vorrichtung (4) von der ersten Konfiguration in die zweite Konfiguration nach Empfang eines Fehler- oder Ausfallerkennungssignals (29) von einem der Halbleiterlaserverstärker (14, 14A) zu bewegen,
wobei die Vorrichtung (4) so ausgelegt ist, dass, in der oder jeden zweiten Konfiguration, für das oder eines der dritte(n) Element(e) (28; 28A, 28B), das zu einem Satz aus Verstärkermodulen (12, 12A) gehört, kein optisches Signal innerhalb des Verstärkermoduls (12) mehr eingespeist wird, das den fehlerhaften oder ausgefallenen Halbleiterlaserverstärker (14, 14A) umfasst;
wobei das oder jedes dritte Element (28; 28A, 28B) dauerhaft fixiert ist und das oder jedes zweite Element (24; 24A, 24B) ein Drehelement ist, das um eine Drehachse befestigt ist, wobei die Bewegungsmittel (18) ausgelegt sind, um das oder jedes zweite Element (24; 24A, 24B) um seine Drehachse anzutreiben.

2. Optische Verstärkungsvorrichtung (4) nach Anspruch 1, wobei, in der ersten Konfiguration der Vorrichtung, wenn ein optisches Eingangssignal (22) innerhalb der oder mindestens einer der optischen Eingangsfaser(n) (6) eingespeist wird, wodurch diese optische(n) Eingangsfaser(n) (6) als aktive optische Eingangsfaser(n) definiert wird (werden), für das oder jedes dritte Element (28; 28A, 28B), das zu einem Satz (10; 10A, 10B) aus Verstärkermodulen (12, 12A) gehört, die Anzahl von Verstärkermodulen (12, 12A) des besagten Satzes strikt höher ist als die Anzahl von aktiven optischen Eingangsfasern (6), die innerhalb des ersten Elements (20; 20A, 20B) angeordnet sind, das dem dritten Element (28; 28A, 28B) zugewandt angeordnet ist, das zu dem besagten Satz aus Verstärkermodulen (12, 12A) gehört.

3. Optische Verstärkungsvorrichtung (4) nach Anspruch 2, wobei, in der oder jeder zweiten Konfiguration der Vorrichtung, für den Satz (10; 10A, 10B) aus Verstärkermodulen (12, 12A) mit dem Verstärkermodul, das den fehlerhaften oder ausgefallenen Halbleiterlaserverstärker (14, 14A) umfasst, das oder eines der Verstärkermodul(e) aus dem besagten Satz, der nicht auf dem optischen Pfad einer aktiven optischen Eingangsfaser in der ersten Konfiguration der Vorrichtung war, auf dem optischen Pfad von einer aktiven optischen Eingangsfaser (6) und einer optischen Ausgangsfaser (8) ist.

4. Optische Verstärkungsvorrichtung (4) nach einem beliebigen der vorstehenden Ansprüche, wobei jedes Verstärkermodul (12) zwei parallele Halbleiterlaserverstärker (14) umfasst, wobei jeder Halbleiterlaserverstärker (14) eine bestimmte Polarisation des empfangenen optischen Eingangssignals (22) verstärken soll.

5. Optische Verstärkungsvorrichtung (4) nach einem beliebigen der vorstehenden Ansprüche, wobei die Überwachungsmittel (16) mindestens zwei Fotodioden (30) umfassen, wobei jede Fotodiode (30) angeordnet ist, um mindestens einen Teil von einem der verstärkten optischen Signale zu empfangen, die von einem Verstärkermodul (12, 12A) bereitgestellt werden.

6. Optische Verstärkungsvorrichtung (4) nach einem beliebigen der vorstehenden Ansprüche, wobei das oder jedes dritte Element (28; 28A, 28B) mindestens eine Linse (38) umfasst, die einem der Halbleiterlaserverstärker (14, 14A), auf einem gleichen optischen Pfad des besagten Verstärkers, vor- oder nachgelagert ist, wobei die besagte Linse (38) zum Fokussieren von Licht ausgelegt ist, das in den besagten Verstärker hineingeht oder von diesem kommt.

7. Optische Verstärkungsvorrichtung (4) nach einem beliebigen der vorstehenden Ansprüche, wobei mindestens eines der ersten (20; 20A, 20B) und zweiten Elemente (24; 24A, 24B) einen Kollimator (34) umfasst, der auf einem gleichen optischen Pfad wie jener von der oder einer der optischen Faser(n) (6, 8) angeordnet ist, die innerhalb des besagten Elements angeordnet ist (sind).

8. Optische Verstärkungsvorrichtung (4) nach Anspruch 7, wobei der Kollimator (34) eine Linse (36) beinhaltet, die zum Fokussieren von Licht ausgelegt ist, das in die oder eine der optische(n) Faser(n) (6, 8), die innerhalb des besagten Elements angeordnet ist (sind), hineingeht oder davon kommt.

9. Optische Verstärkungsvorrichtung (4) nach einem beliebigen der vorstehenden Ansprüche, wobei die die Anzahl von Verstärkermodulen (12, 12A) strikt höher ist als die Anzahl von optischen Ausgangsfasern (8).

10. Optische Verstärkungsvorrichtung (4) nach einem beliebigen der vorstehenden Ansprüche, wobei die Vorrichtung mindestens zwei Sätze aus mindestens zwei optischen Eingangsfasern (6) und mindestens zwei Sätze aus mindestens zwei optischen Ausgangsfasern (8) umfasst, wobei die Vorrichtung (4) weiterhin mindestens zwei Sätze (10A, 10B) aus mindestens drei Verstärkermodulen (12) umfasst, die optischen Eingangsfasern (6) von getrennten Sätzen aus optischen Eingangsfasern innerhalb von getrennten ersten Elementen (20A, 20B) angeordnet sind, die optischen Ausgangsfasern (8) von getrennten Sätzen aus optischen Ausgangsfasern innerhalb von getrennten zweiten Elementen (24A, 24B) angeordnet sind, die Verstärkermodule (12) von getrennten Sätzen (10A, 10B) aus Verstärkermodulen innerhalb von getrennten dritten Elementen (28A, 28B) angeordnet sind.

11. Optische Verstärkungsvorrichtung (4) nach einem beliebigen der vorstehenden Ansprüche, wobei das oder jedes dritte Element (28; 28A, 28B) dauerhaft fixiert ist und das oder jedes erste Element (20; 20A, 20B) ein Drehelement ist, das um eine Drehachse befestigt ist, wobei die Bewegungsmittel (18) ausgelegt sind, um das oder jedes erste Element (20; 20A, 20B) um seine Drehachse anzutreiben, um die Vorrichtung (4) von der ersten Konfiguration in die oder jede zweite Konfiguration zu bewegen.

12. Optisches Kommunikationssystem (2), umfassend eine Vielzahl von hintereinander geschalteten, optischen Verstärkungsvorrichtungen (4), wobei jede optische Verstärkungsvorrichtung (4) einem beliebigen der vorstehenden Ansprüche entspricht.

13. Optisches Kommunikationssystem (2) nach Anspruch 11, wobei das optische Kommunikationssystem (2) ein Unterwassersystem ist.

## Revendications

1. Dispositif d'amplification optique (4) comprenant :
• au moins une fibre optique d'entrée (6) disposée dans un premier élément (20 ; 20A, 20B) et destinée à recevoir un signal optique d'entrée (22),
• au moins une fibre optique de sortie (8) disposée dans un deuxième élément (24 ; 24A, 24B) et destinée à fournir un signal optique de sortie (26),
• au moins un ensemble (10 ; 10A, 10B) d'au moins deux modules d'amplificateur (12, 12A), l'ensemble ou chaque ensemble (10; 10A, 10B) de modules d'amplificateur (12, 12A) étant disposé dans un troisième élément (28 ; 28A, 28B), chaque module d'amplificateur (12, 12A) comprenant au moins un amplificateur optique à semi-conducteur (14, 14A), le troisième élément ou chaque troisième élément (28 ; 28A, 28B) étant disposé entre le premier élément ou un des premiers éléments (20 ; 20A, 20B) et le deuxième élément ou un des deuxièmes éléments (24 ; 24A, 24B) de sorte que, dans une première configuration du dispositif (4), au moins un module d'amplificateur (12) de l'ensemble (10 ; 10A, 10B) disposé dans ledit troisième élément soit sur le trajet optique d'une fibre optique d'entrée (6) et d'une fibre optique de sortie (8),
• des moyens (16) pour surveiller l'état de chaque amplificateur optique à semi-conducteur (14, 14A), les moyens (16) étant configurés pour détecter un défaut ou une défaillance dudit amplificateur optique à semi-conducteur,
• des moyens (18) pour déplacer mécaniquement le dispositif (4) entre la première configuration et au moins une deuxième configuration, lesdits moyens de déplacement (18) étant connectés aux moyens de surveillance (16) de sorte que les moyens de déplacement (18) soient adaptés pour déplacer le dispositif (4) entre la première configuration et la deuxième configuration lors de la réception d'un signal de détection de défaut ou de défaillance (29) d'un des amplificateurs optiques à semi-conducteur (14, 14A),
le dispositif (4) étant configuré de sorte que, dans la deuxième configuration ou dans chaque deuxième configuration, pour le troisième élément ou pour un des troisièmes éléments (28 ; 28A, 28B) associé à un ensemble de modules d'amplificateur (12, 12A), plus aucun signal optique ne soit injecté dans le module d'amplificateur (12) comprenant l'amplificateur optique à semi-conducteur présentant un défaut ou une défaillance (14, 14A) ;
dans lequel le troisième élément ou chaque troisième élément (28 ; 28A, 28B) est constamment fixe et le deuxième élément ou chaque deuxième élément (24 ; 24A, 24B) est un élément rotatif monté autour d'un axe de rotation, les moyens de déplacement (18) étant configurés pour entraîner le deuxième élément ou chaque deuxième élément (24 ; 24A, 24B) autour de son axe de rotation.

2. Dispositif d'amplification optique (4) selon la revendication 1, dans lequel, dans la première configuration du dispositif, lorsqu'un signal optique d'entrée (22) est injecté dans la fibre optique d'entrée ou au moins une des fibres optiques d'entrée (6), définissant ainsi cette/ces fibre(s) optique(s) d'entrée (6) en tant que fibre(s) optique(s) d'entrée active(s), pour le troisième élément ou pour chaque troisième élément (28; 28A, 28B) associé à un ensemble (10; 10A, 10B) de modules d'amplificateur (12, 12A), le nombre de modules d'amplificateur (12, 12A) dudit ensemble est strictement supérieur au nombre de fibre(s) optique(s) d'entrée active(s) (6) disposée(s) dans le premier élément (20 ; 20A, 20B) qui est disposé en face du troisième élément (28 ; 28A, 28B) associé audit ensemble de modules d'amplificateur (12, 12A).

3. Dispositif d'amplification optique (4) selon la revendication 2, dans lequel, dans la deuxième configuration ou dans chaque deuxième configuration du dispositif, pour l'ensemble (10 ; 10A, 10B) de modules d'amplificateur (12, 12A) ayant le module d'amplificateur comprenant l'amplificateur optique à semi-conducteur présentant un défaut ou une défaillance (14, 14A), le module d'amplificateur ou un des modules d'amplificateur dudit ensemble qui n'a pas été sur le trajet optique d'une fibre optique d'entrée active dans la première configuration du dispositif est sur le trajet optique d'une fibre optique d'entrée active (6) et d'une fibre optique de sortie (8).

4. Dispositif d'amplification optique (4) selon l'une quelconque des revendications précédentes, dans lequel chaque module d'amplificateur (12) comprend deux amplificateurs optiques à semi-conducteur parallèles (14), chaque amplificateur optique à semi-conducteur (14) étant destiné à amplifier une polarisation particulière du signal optique d'entrée (22) reçu.

5. Dispositif d'amplification optique (4) selon l'une quelconque des revendications précédentes, dans lequel les moyens de surveillance (16) comprennent au moins deux photodiodes (30), chaque photodiode (30) étant disposée de sorte à recevoir au moins une partie d'un des signaux optiques amplifiés fournis par un module d'amplificateur (12, 12A).

6. Dispositif d'amplification optique (4) selon l'une quelconque des revendications précédentes, dans lequel le troisième élément ou chaque troisième élément (28 ; 28A, 28B) comprend au moins une lentille (38) disposée en amont ou en aval d'un des amplificateurs optiques à semi-conducteur (14, 14A), sur un même trajet optique dudit amplificateur, ladite lentille (38) étant configurée pour focaliser la lumière entrant dans ledit amplificateur ou sortant de celui-ci.

7. Dispositif d'amplification optique (4) selon l'une quelconque des revendications précédentes, dans lequel au moins un élément parmi le premier élément (20 ; 20A, 20B) et le deuxième élément (24 ; 24A, 24B) comprend un collimateur (34) disposé sur un même trajet optique que celui de la fibre optique ou d'une des fibres optiques (6, 8) qui est disposée dans ledit élément.

8. Dispositif d'amplification optique (4) selon la revendication 7, dans lequel le collimateur (34) comprend une lentille (36) configurée pour focaliser la lumière entrant dans la fibre optique ou dans une des fibres optiques (6, 8) ou sortant de celle-ci/celles-ci qui est disposée dans ledit élément.

9. Dispositif d'amplification optique (4) selon l'une quelconque des revendications précédentes, dans lequel le nombre de modules d'amplificateur (12, 12A) est strictement supérieur au nombre de fibre(s) optique(s) de sortie (8).

10. Dispositif d'amplification optique (4) selon l'une quelconque des revendications précédentes, le dispositif comprenant au moins deux ensembles d'au moins deux fibres optiques d'entrée (6) et au moins deux ensembles d'au moins deux fibres optiques de sortie (8), le dispositif (4) comprenant en outre au moins deux ensembles (10A, 10B) d'au moins trois modules d'amplificateur (12), les fibres optiques d'entrée (6) d'ensembles séparés de fibres optiques d'entrée étant disposées dans des premiers éléments (20A, 20B) séparés, les fibres optiques de sortie (8) d'ensembles séparés de fibres optiques de sortie étant disposées dans des deuxièmes éléments (24A, 24B) séparés, les modules d'amplificateur (12) d'ensembles (10A, 10B) séparés de modules d'amplificateur étant disposés dans des troisièmes éléments (28A, 28B) séparés.

11. Dispositif d'amplification optique (4) selon l'une quelconque des revendications précédentes, dans lequel le troisième élément ou chaque troisième élément (28 ; 28A, 28B) est constamment fixe, et le premier élément ou chaque premier élément (20 ; 20A, 20B) est un élément rotatif monté autour d'un axe de rotation, les moyens de déplacement (18) étant configurés pour entraîner le premier élément ou chaque premier élément (20 ; 20A, 20B) autour de son axe de rotation, de sorte à déplacer le dispositif (4) entre la première configuration et la deuxième configuration ou chaque deuxième configuration.

12. Système de communication optique (2) comprenant une pluralité de dispositifs d'amplification optique en cascade (4), dans lequel chaque dispositif d'amplification optique (4) est selon l'une quelconque des revendications précédentes.

13. Système de communication optique (2) selon la revendication 11, le système de communication optique (2) étant un système sous-marin.
